# EUROPÄISCHE PATENTSCHRIFT

(11) **EP 2 060 513 B1**
(45) Veröffentlichungstag und Bekanntmachung des Hinweises auf die Patenterteilung: **06.10.2010**
(21) Anmeldenummer: 08019695.9
(22) Anmeldetag: 11.11.2008
(51) Int. Cl.: B65G 47/22

(54) **Vorrichtung und Verfahren zum spurgenauen Transport von Substraten**
Device and method to precisely transport substrates on tracks
Dispositif et méthode pour le transport précis de substrats sur des voies

(30) Priorität: 13.11.2007 DE 102007054089
(43) Veröffentlichungstag der Anmeldung: 20.05.2009
(73) Patentinhaber: Rena Sondermaschinen GmbH, 78148 Gütenbach (DE)
(72) Erfinder: Hübel, Egon, 90537 Feucht (DE)
(74) Vertreter: Stürken, Joachim

(56) Entgegenhaltungen:
- DE-A1- 2 211 628
- DE-A1- 10 107 004
- US-A- 2 249 505
- US-A- 3 089 576
- US-A- 4 607 831
- US-B1- 6 454 257

## Beschreibung

Die Erfindung betrifft den Transport von Gut als flache Abschnitte oder als räumliche Gegenstände wie z.B. Werkstücke oder anderes Stückgut, das nacheinander mit kleinem Abstand in die Anlage einfährt. Zur Förderung des Gutes in einer Transportebene und bevorzugt in einer Richtung dienen angetriebene Transportrollen oder Walzen von so genannten Rollenförderern. Diese fördern das Gut in horizontaler Ausrichtung, z.B. in Durchlaufanlagen. Bei den Anlagen kann es sich um Nassanlagen oder um Förderanlagen zur Trockenbehandlung von Gut handeln.

Ein Anwendungsgebiet betrifft den Transport von z.B. Substraten als Wafer, Solarzellen, Hybride oder um Leiterplatten, Glasscheiben, Bleche aus Metall oder Kunststoff und dergleichen. Diese Güter werden in der Durchlaufanlage nasschemisch oder elektrolytisch behandelt. Weitere Nassprozesse sind z.B. das Reinigen und Spülen. Zur Trockenbehandlung gehören alle Prozesse, die eine Förderung von Gut als flache Abschnitte oder räumliche Gegenstände auf Fördermitteln als Walzen, Rollen, Scheiben, Rädchen oder dergleichen erfordern. Als Beispiel sei hier das präzise Bedrucken, Laminieren oder Beschriften von Gut, das auf einem Rollenförderer gefördert wird, genannt.

### Stand der Technik und Nachteile

Weil die Durchlaufanlagen in der Regel in Transportrichtung lang sind, z.B. 10 Meter und mehr, ist eine spurgenaue Förderung der im Vergleich hierzu sehr kurzen Güter unerlässlich, besonders dann, wenn mehrere Güter parallel durch die Durchlaufanlage gefördert werden. Bei einem "aus der Spur Laufen" der Güter können diese beschädigt werden und/oder es kommt zu einem Transportstau. Beides muss verhindert werden.

Die Druckschrift DE 103 91 511 B4 beschreibt ein Transportsystem mit Transportrollen für flaches Transportgut. Rotierende Achsen sind quer zur Transportrichtung entlang der Durchlaufanlage angeordnet. Für jede Spur des parallel zu fördernden Gutes befinden sich auf den Achsen jeweils zwei Auflageelemente und zwei Spurhalter. Das Gut liegt auf den rotierenden Achsen auf und wird von diesen in einer Richtung durch die Durchlaufanlage gefördert. Die zu beiden Seiten der Spur und damit auch zu beiden Seiten des Gutes angeordneten rotierenden Spurhalter begrenzen die Spur und damit auch die Transportbahn des Gutes. Es kann nicht "aus der Spur Laufen", wenn die Achsen in genügend kleinem Abstand in der Durchlaufanlage angeordnet sind. Bei besonders scharfkantigem Gut besteht jedoch die Gefahr, dass dieses in Folge von Reibung von einem der beiden Spurhalter angehoben und mitgenommen wird. Wegen des größeren Durchmessers steigt das Gut einseitig nach oben, wodurch die Transportgeschwindigkeit in Folge dieses größeren Durchmessers einseitig zunimmt. Das Gut kann dadurch beschädigt werden, insbesondere wenn es bruchempfindlich ist.

Ein weiteres Transportsystem für ebenes, flaches Gut, z.B. für LC-Displays oder Solarzellen beschreibt die Druckschrift DE 102 09 779 A1. Das Gut wird beidseitig von oberen und unteren Transporträdern 13 erfasst und transportiert. Zur Vermeidung eines "aus der Spur Laufens" sind außen an den Transporträdern konische Bordscheiben angeordnet. Diese rotierenden Bordscheiben schieben das Gut immer wieder in die korrekte Spur. Dabei kann es zu den gleichen Transportproblemen kommen, wie bei dem oben beschriebenen Transportsystem.

Wegen der Gefahr des Auflaufens auf die konischen Bordscheiben bzw. Spurhalter wird in der Praxis auch auf diese verzichtet. In diesen Durchlaufanlagen wird nach einer bestimmten Transportstrecke eine Richtstation eingefügt, die der Spurkorrektur des Gutes dient. Nachteilig ist jedoch, dass dadurch die Anlage insgesamt wesentlich länger wird, insbesondere wenn aus Sicherheitsgründen bereits nach wenigen Metern einer Durchlaufanlage in Transportrichtung eine Richtstation eingefügt werden muss.

US 2 249 505 A1 offenbart eine Transportvorrichtung mit einem verlagerbaren Korrekturmittel, des flache Güten ausrichtet.

Aufgabe der Erfindung ist es, eine Vorrichtung und ein Verfahren zur Spurkorrektur von flachem Gut oder räumlichen Gegenständen beim Transport in Durchlaufanlagen oder auf anderen transportierenden Anlagen zu beschreiben, welche die genannten Nachteile des Standes der Technik nicht aufweisen. Insbesondere sollen sie auch für sehr bruchempfindliches Gut geeignet sein und die Länge der Durchlaufanlage nicht erhöhen.

Gelöst wird die Aufgabe durch die Vorrichtung nach Patentanspruch 1 und durch das Verfahren nach Patentanspruch 12. Die Unteransprüche beschreiben vorteilhafte Ausführungen der Erfindung.

### Beschreibung

Die Erfindung sieht über rotierende Wellen angetriebene Fördermittel vor, die entlang der Transportbahn bzw. -ebene mindestens an der Unterseite des zu transportierenden Gutes angeordnet sind. Auf den Wellen sind Transporträdchen oder Transportwalzen angeordnet. Bevorzugt an der Unterseite befindet sich für jedes parallele Gut, d.h. für jede Transportspur z.B. eine Spurwalze. Diese ist in erster Näherung in axialer Richtung so lang, wie das Gut quer zur Transportrichtung breit ist. An den beiden Stirnseiten der Spurwalze befindet sich mindestens ein Korrekturmittel, das bevorzugt auf der Welle und mit der Spurwalze rotiert. Das Korrekturmittel hat einen Radius, der größer ist als der Radius der Spurwalze. Das Korrekturmittel ist so beabstandet oder vorgespannt, dass es nicht an der Stirnseite der Spurwalze anliegt. Bei der Rotation der Spurwalze wird das Korrekturmittel von einer stehenden Nocke immer dann kurzzeitig in Richtung zur Transportspur der Spurwalze und damit zum Gut verlagert, wenn es sich in der Nähe der Transportebene befindet. Ein aus der Spur gelaufenes Gut wird dadurch wieder in die korrekte Spur geschoben. Die axiale kurzzeitige Verlagerung des Korrekturmittels kann durch Bewegungen wie z.B. Schieben, Drücken, Schwenken, Kippen, oder Taumeln erfolgen.

Das Korrekturmittel wirkt stirnseitig, d.h. auf eine Kante des flachen Gutes, das in dieser Richtung sehr stabil und nicht bruchempfindlich ist, oder auf eine Seite des räumlichen Gegenstandes.

Besonders vorteilhaft ist es, dass für die Bewegung zum Ausrichten des Gutes mittels der Korrekturmittel, von Ausnahme abgesehen, kein gesonderter Antrieb erforderlich ist. Die Bewegung wird bevorzugt vom vorhandenen Transportantrieb abgeleitet. Die Korrekturschieber zu beiden Seiten der Transportspur können in Transportrichtung abwechselnd an den Spurwalzen angeordnet werden.

Die Erfindung wird nachfolgend an Hand der Figuren 1 bis 4 detailliert beschrieben.

### Figurenbeschreibung

**Figur 1** zeigt am Beispiel des Standes der Technik die grundsätzliche Aufgabenstellung zum sicheren Transport von Gut.
**Figur 2** zeigt die Anordnungen der Korrekturmittel als Korrekturschieber an den Transportwellen in einer Durchlaufanlage.
**Figur 3** zeigt ein Ausführungsbeispiel der erfindungsgemäßen Vorrichtung im Ausschnitt mit federnden Korrekturmitteln als Korrekturschieber.
**Figur 4** zeigt ein weiteres Ausführungsbeispiel der erfindungsgemäßen Vorrichtung mit Korrekturmitteln als verlagerbare Nockenscheiben.

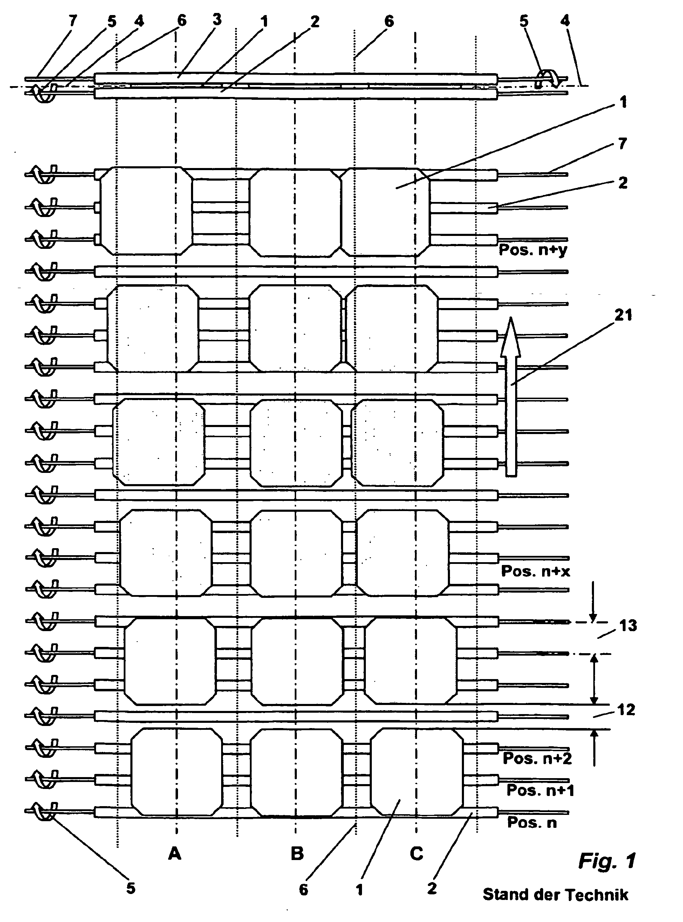

Die **Figur 1** zeigt in der Draufsicht einen Ausschnitt einer Durchlaufanlage mit in horizontaler Lage von unteren Transportwalzen 2 geförderten Abschnitten als Gut 1. Der Antrieb der Transportwalzen ist mit den Antriebspfeilen 5 symbolisch dargestellt. Die Transportrichtung des Gutes 1 zeigt der Transportrichtungspfeil 21. In Abhängigkeit vom Prozess zur Behandlung des Gutes 1 sind nicht immer obere Transportwalzen 3 erforderlich. In der oben dargestellten Längssicht sind diese dargestellt. So sind obere Transportwalzen 3 z.B. dann erforderlich, wenn die Unterseite des Gutes 1 bei einer Nassbehandlung von Sprüh- oder Spritzstrahlen erfasst wird. Sie sind auch dann erforderlich, wenn bei einer elektrolytischen Behandlung eine Kontaktkraft zur elektrischen Stromübertragung auf das Gut 1 erfolgt. Bei einem Transport im Trockenen, z.B. zum Beschriften mittels Laser oder zum Bedrucken sind obere Transportwalzen 3 nicht erforderlich. Das Gut 1 als Abschnitt oder räumlicher Gegenstand wird in diesem Falle bei der Behandlung gegen die unteren Transportwalzen gedrückt. In der gleichen Richtung wirkt die oft ausreichende Schwerkraft.

In der Figur 1 sind quer zur Transportrichtung drei Spuren mit der Bezeichnung A, B und C dargestellt. Auf diesen drei Spuren werden z.B. gleich große Güter 1 parallel durch die Durchlaufanlage gefördert. In der Position n befinden sich alle drei Güter genau in der Mitte ihrer Spur. Im Verlauf des Transportes hält als Beispiel das Gut der Spur B die vorgegebene Spur genau ein. Hierfür wäre keine Spurkorrektur erforderlich. Bei den anderen beiden Spuren A und C driftet das hintereinander geförderte Gut 1 nach links ab. Bereits bei der Position n+x werden die zulässigen Toleranzgrenzen oder Bereichsgrenzen 6 erreicht. Dies bedeutet, dass bei oder nach dieser Position eine Spurkorrektur erfolgen sollte. Erfolgt dies nicht, so wie es die Figur 1 zeigt, dann läuft das Gut 1 der Spur C auf das Gut 1 der Spur B bei der Position n+y seitlich auf. In der Regel führt dies zur Beschädigung des Gutes und/oder zu einem Stau der geförderten Güter. Daher sind nach bestimmten Abständen in Transportrichtung aus Sicherheitsgründen Maßnahmen zur Korrektur der Spuren erforderlich. Die Abstände der Vorrichtungen zur Spurkorrektur richten sich nach der mechanischen Präzision der Transportmittel in Bezug zur zulässigen Toleranz und nach der Größe des Spurbereiches in Bezug zur Breite des Gutes quer zur Transportrichtung. Aus Gründen der Transportsicherheit sollten die Abstände klein gehalten werden, z.B. nach jedem Meter. Dagegen sprechen die dafür aufzuwendenden Kosten und gegebenenfalls der erforderliche Raum zur Unterbringung der Konstruktionselemente, wodurch die Anlage in Transportrichtung verlängert wird.

Die erfindungsgemäße Vorrichtung lässt sich überraschend mit vergleichsweise kostengünstigen Mitteln realisieren. Sie benötigt auch keinen zusätzlichen Raum in Transportrichtung. Von daher kann die Vorrichtung in kürzeren Abständen in der Durchlaufanlage eingebaut werden, wodurch die Transportsicherheit wesentlich erhöht wird.

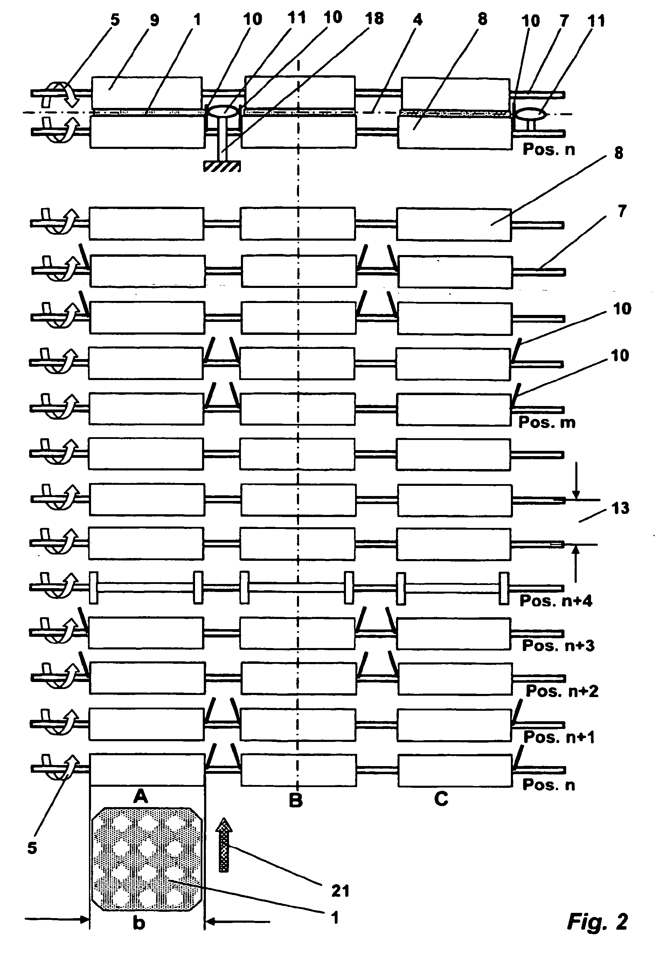

Die **Figur 2** zeigt eine erfindungsgemäße Durchlaufanlage in der Draufsicht und im oberen Teil der Figur 2 in der Längssicht. Schematisch sind die erfindungsgemäßen Vorrichtungen eingezeichnet. Die als untere Transportwalzen 2 ausgebildeten Transportmittel mit durchgehenden rotierend angetriebenen Wellen 7 nach dem Stand der Technik sind hier axial in Abschnitte für jede Spur geteilt. Diese Abschnitte werden nachfolgend als untere Spurwalze 8 und obere Spurwalze 9 bezeichnet. Die Spurwalzen 8, 9 können z.B. auch reduziert an den Rändern der Spur als Randscheiben ausgeführt sein, so wie es in der Position n+4 dargestellt ist. Die axiale Länge der Spurwalze ist mindestens so groß wie die Breite b des Gutes 1 quer zur Transportrichtung. Maximal wird die axiale Länge der Spurwalze von den Bereichsgrenzen der Spur bestimmt. In der oben dargestellten Längssicht, mit der Situation an der Position n, weisen die als bewegliche Korrekturschieber 10 ausgebildeten Korrekturmittel senkrecht nach oben. In dieser Phasenlage ϕ der 360° Rotation der Spurwalzen, die nachfolgend als ϕ = 0° bezeichnet wird, sind die zwei Korrekturschieber 10 auf die bei ϕ = 0° stehenden Nockenbahnen 11 aufgelaufen. Dadurch werden die oberen Bereiche der Korrekturschieber 10 nach beiden Seiten in axialer Richtung gedrückt bzw. verlagert. Falls das Gut 1 aus der Spur gelaufen ist, und zwar in Richtung zur Nockenbahn 11, wird es von den Korrekturschiebern 10 zurückgeschoben. Wegen der einfachen mechanischen Ausführung können in Transportrichtung gesehen öfters derartige Korrekturschieber angeordnet werden, so dass stets nur ein kleiner Korrekturschub erforderlich ist.

Vorteilhaft ist die gleiche Anordnung der Korrekturschieber bei mindestens zwei aufeinander folgenden Positionen wie sie z.B. bei den Positionen n und n+1 dargestellt sind. Dadurch wird auch ein in Transportrichtung kurzes Gut von zwei Korrekturschiebern gleichzeitig parallel verschoben. Bei einem einzigen korrigierenden Korrekturschieber könnte ein unerwünschtes Verdrehen des Gutes auftreten. Wenn das Gut nicht wie dargestellt in Richtung zur Nockenbahn 11 gedriftet ist, sondern in die entgegengesetzte Richtung, dann erfolgt die Korrektur an den nachfolgenden beiden Positionen, d.h. an den Positionen n+2 und n+3 mit den dort angeordneten Korrekturschiebern und Nockenbahnen.

Nach der Korrekturstrecke bei den Position n bis n+3 ist erst ab der Position m wieder eine Korrekturstrecke erforderlich. Die Länge des Bereiches ohne Korrekturmittel richtet sich nach den allgemeinen Bedingungen des Transportes in der Durchlaufanlage. Die Anzahl der gleichartig angeordneten Korrekturschieber beschränkt sich nicht auf die jeweils zwei dargestellten Korrekturschieber. Es können auch mehrere sein, insbesondere wenn das Gut in Transportrichtung lang ist im Vergleich zum Abstand 13 der Spurwalzen in dieser Richtung. Dieser Fall besteht z.B. bei einer Durchlaufanlage zur Behandlung von Leiterplatten. Meist gibt es wegen deren großer Breite nur eine Spur.

Das Gegenteil ist der Fall beim Transport von Wafern, Hybriden oder Solarzellen. Hier können z.B. 10 Spuren zur parallelen Förderung des Gutes vorkommen. Derartig kleines Gut mit einer Fläche von z.B. 1 dm² ist für eine Produktionsanlage in der Regel stets gleich groß. Dies kann vorteilhaft für die erfindungsgemäße Vorrichtung genutzt werden, um zu erreichen, dass das schiebende axiale Korrigieren des aus der Spur gedrifteten Gutes immer dann erfolgt, wenn mindestens zwei Korrekturschieber bzw. Korrekturmittel in Transportrichtung symmetrisch der Kante des Gutes in der Transportebene 4 gegenüber stehen. Dadurch wird vermieden, dass ein Korrekturschieber auf eine Querlücke 12 trifft, die zwischen zwei aufeinander folgenden Gütern besteht. Dies könnte zum Verdrehen des Gutes führen.

Um das symmetrische Treffen zu erreichen, muss der Umfang u der Spurwalzen so groß gewählt werden, wie die Länge L_{g} des Gutes plus die Länge L_{qlü} der Querlücke beträgt. Die Summe der Längen L_{g} + L_{qlü} wird nachfolgend als Bruttogutlänge L_{gbr} bezeichnet. Des Weiteren müssen die Antriebe aller Spurwalzen 8, 9 untereinander synchronisiert, d.h. in einer unveränderlichen Beziehung stehen. Dies ist bei den bekannten Durchlaufanlagen gegeben. Eine Transmissionswelle entlang der Transportbahn treibt formschlüssig mittels Kegelzahnrädern oder Zahnriemen die Wellen 7 der Spurwalzen an. Gleiches wird durch elektrische Synchronantriebe erreicht. Unter diesen Voraussetzungen steht jeder Korrekturschieber 10 nach der Förderung einer Bruttogutlänge L_{gbr} exakt wieder an dem gleichen Phasenwinkel ϕ der Spurwalze. Durch Verdrehen und Fixieren der Korrekturschieber auf den Wellen 7 erfolgt die für das Gut günstigste Phaseneinstellung einmalig bei der Inbetriebnahme der Durchlaufanlage. Für einen bestimmten, sich immer wiederholenden Startzeitpunkt des Gutes in die Durchlaufanlage werden die Phasenwinkel ϕ der mit der Welle 7 rotierenden Korrekturschieber so eingestellt und fixiert, dass sie z.B. paarweise und symmetrisch die jeweilige Kante des Gutes, die parallel zur Bereichsgrenze 6 verläuft, treffen. Dies verhindert ein Verdrehen des Gutes bei der Korrektur. In der **Figur 2** sind die Korrekturschieber in der Draufsicht aus Gründen der Darstellung bei einem Phasenwinkel von ϕ = 90° dargestellt. In der Längssicht dagegen beträgt dieser Winkel ϕ = 0°.

Zur Vermeidung von vielen individuellen Einstellungen der Phasenwinkel einzelner Spurwalzen entlang der Durchlaufanlage sind definierte Abstände 13 der Wellen 7 der Spurwalzen in Transportrichtung einzuhalten. Der Abstand 13 kann der Bruttogutlänge L_{gbr} entsprechen. Er kann auch ein Vielfaches oder ein Stammbruchteil von L_{gbr} betragen. In diesen Fällen ergeben sich zum symmetrischen Korrigieren des Gutes mittels der Korrekturschieber gleiche Einstellungen der Phasenwinkel ϕ für die Korrekturschieber auf allen Wellen 7 der Durchlaufanlage, die Mittel zur Korrektur aufweisen. Zwischen diesen Wellen 7 können auch nicht korrigierende rotierende oder nicht rotierende Transportmittel angeordnet sein.

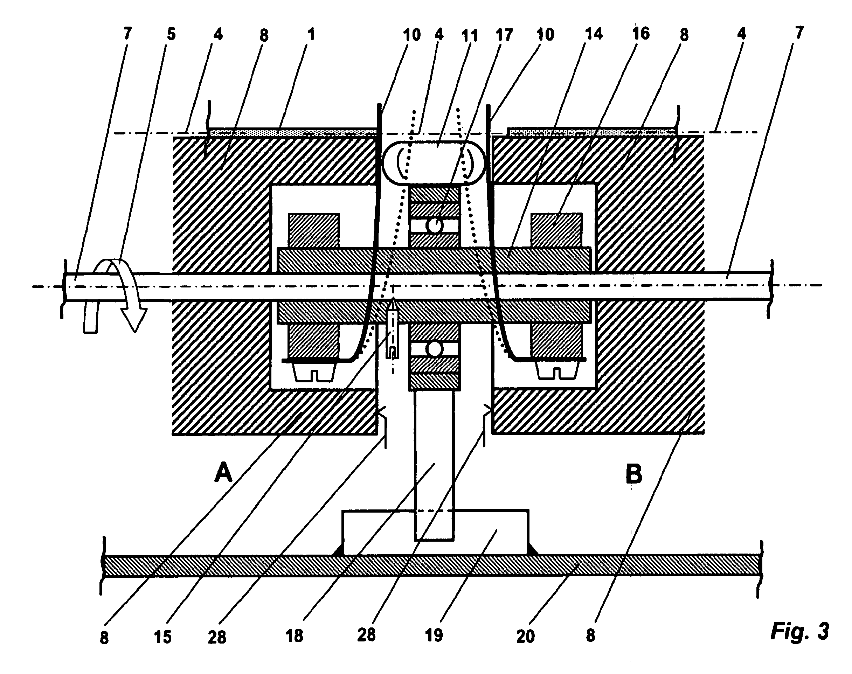

Die **Figur 3** zeigt Einzelheiten einer ersten möglichen Ausführung der Korrekturmittel als Korrekturschieber 10 und der Nockenbahn 11. Die Erfindung beschränkt sich jedoch nicht auf diese konstruktive Ausführung. Im Schnittbild sind das stirnseitige Ende der unteren Spurwalze 8 der Spur A und der Anfang der unteren Spurwalze 8 der Spur B dargestellt. Diese Spurwalzen 8 sind auf der angetriebenen unteren Welle 7 angeordnet und befestigt. Ihre Stirnseiten 28 sind zur Erreichung eines kleinen Abstandes zwischen den Spuren ausgehöhlt, d.h. eingedreht. Auf der Welle 7 befindet sich verdrehbar eine Hülse 14 zur Aufnahme der weiteren Konstruktionselemente. Sie dient zur Einstellung und Fixierung des Phasenwinkels ϕ der Korrekturschieber 10. Die Fixierung erfolgt z.B. mittels einer Justierschraube 15. Die Hülse 14 trägt über je ein Zwischenstück 16 die Korrekturschieber 10. Diese weisen die Eigenschaften einer Feder auf. Im entspannten, mit Punkten dargestellten Zustand der federnden Korrekturschieber sind ihre Enden im Bereich der Transportebene 4 beabstandet von den Stirnseiten 28 der unteren Spurwalzen 8. Die Korrekturschieber rotieren mit den Spurwalzen 8. Im Bereich des Phasenwinkels ϕ = 0°, d.h. an der höchstgelegenen Mantellinie der Spurwalze in der Nähe des Gutes 1 und im Bereich der Transportebene 4, befindet sich eine stationäre Nockenbahn 11. Sie ist dort in diesem Beispiel mittels eines sie tragenden Lagers 17 als Wälzlager positioniert. Damit sich der äußere Lagerring nicht verdrehen kann, wird er von einem Schenkel 18 fixiert. Der Schenkel 18 schlägt an einem Anschlag 19 an, der am Boden 20 des Arbeitsbehälters befestigt ist. Die lose Begrenzung von Schenkel 18 und Anschlag 19 erlauben den einfachen Ein- und Ausbau der Welle 7 mit den Spurwalzen 8, Lagern 17 und den Nockenbahnen 11.

Die stehende Nockenbahn 11 wird von der Welle 7 getragen, die auch die Spurwalzen 8 trägt. Damit ist auch bei langen, sich durchbiegenden Wellen 7 mit vielen darauf angeordneten Spurwalzen 8 stets eine exakte Höhenlage der Nockenbahn 11 zur Spurwalze und zu den Korrekturschiebern sichergestellt. Die stationäre Nockenbahn 11 kann auch direkt am Boden 20 des Arbeitsbehälters befestigt werden, wenn Toleranzen der Wellen 7 nicht zu erwarten sind.

Wenn sich die Korrekturschieber bei der Rotation dem Phasenwinkel ϕ = 0° nähern, d.h. der Transportebene 4, dann schieben diese durch ihre kurzzeitige Verlagerung ein Gut 1 zurück, falls dieses in Richtung zum Korrekturschieber aus der Spur gelaufen ist. In der Figur 3 war dies bei der Spur A der Fall. Bei der Spur B war ein Korrigieren an dieser Seite nicht erforderlich. Möglicherweise aber an der anderen, hier nicht dargestellten Seite der Spur B. Diese Korrektur in der anderen Richtung kann in derselben Position der Durchlaufanlage erfolgen, also auf derselben Welle 7 oder in den unmittelbar darauf folgenden Positionen, so wie es in der Draufsicht der Figur 2 dargestellt ist. Das wechselseitige Korrigieren ist besonders dann zu wählen, wenn die Breite des Gutes mit Toleranzen behaftet ist, die so groß werden können, dass die axiale Länge der Spurwalzen überschritten wird.

Die flachen federnden Korrekturschieber können im Bereich des Gutes 1 ein nicht dargestelltes rundes oder halbrundes Profil aufweisen, damit auch ein weit aus der Spur gelaufenes Gut abgewiesen und nicht blockiert wird.

Die Vorrichtung zur Korrektur des Gutes wurde vorstehend mit Korrekturschiebern, die weitgehend unterhalb der Transportebene 4 angeordnet sind, beschrieben. Alle Vorrichtungen zur Korrektur können auch oberhalb der Transportebene 4 wie z.B. an mindestens einem oberen Fördermittel 3 wie einer Spurwalze 9 spiegelbildlich angeordnet werden, wobei die Nockenbahn, wie dargestellt, auf der unteren Welle 7 gelagert werden kann. Sie kann auch an einem anderen Fixpunkt des Arbeitsbehälters befestigt werden.

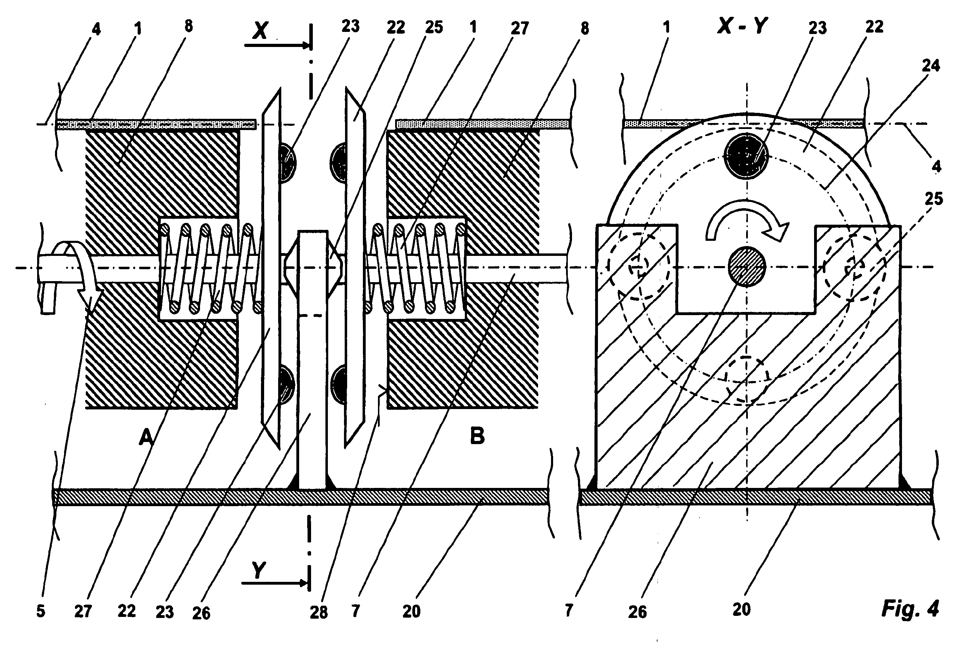

Die **Figur 4** zeigt ein weiteres Ausführungsbeispiel der Erfindung als Schnittbild zwischen den unteren Spurwalzen 8 der Spuren A und B sowie das Schnittbild X - Y. Auf der rotierend angetriebenen Welle 7 befinden sich mindestens die hier dargestellten unteren Spurwalzen 8. Des Weiteren sind auf der Welle 7 axial verlagerbare und als Nockenscheiben ausgebildete Korrekturmittel 22 angeordnet, die gegen ein Verdrehen auf der Welle 7 gesichert sind. Eine Verdrehsicherung kann z.B. durch eine Welle 7 mit einem vieleckigen Profil im Bereich der Nockenscheiben realisiert werden. Auf den beiden Nockenscheiben 22 sind auf einem Teilkreis 24 jeweils zwei Nocken 23 angeordnet, die gegeneinander um 180° versetzt sind. Je zwei Gegennocken 25 sind auf einem gleich großen Teilkreis mit gleicher Teilung an einer Konsole 26 stationär angeordnet. Die Konsole ist z.B. am Boden 20 des Arbeitsbehälters befestigt. Sie ist an der nach oben weisenden Seite so ausgespart, dass die Welle 7 mit den unteren Spurwalzen 8 montierbar und demontierbar bleibt. Die stationären Gegennocken 25 können auch mit ihrer Konsole auf der Welle 7 angeordnet werden, so wie es das Beispiel der Figur 3 zeigt. Bei einer Anordnung der Nockenbahn 11 oder der Gegennocken 25 aufweisenden Konsole 26 auf der Welle 7 erfolgt die Korrektur von Höhenabweichungen der Wellen 7 zu den Korrekturmitteln 10 bzw. 22 selbsttätig.

Bei Rotation der Welle 7 laufen die Nocken 23 auf die stationären Gegennocken 25 auf. Dabei verlagert bzw. verschiebt sich kurzzeitig die Nockenscheibe 22 gegen die Kraft der Druckfeder 27 in Richtung zur zugeordneten Stirnseite 28 der Spurwalze 8. Ein Gut 1, das aus der Bahn gelaufen ist, wird dadurch in die korrekte Spur zurückgeschoben. Dieser Fall liegt bei der Spur A vor. Die Korrektur erfolgt dort bei der dargestellten Situation nach einer weiteren Drehung der Welle 7 und damit auch der Nockenscheibe 22 um 90°. Das Gut 1 der Spur B hat zumindest an dieser Bereichsgrenze die korrekte Lage. Die auch dort kurzzeitig axial verschobene Nockenscheibe 22 erreicht die Stirnseite 28 der Spurwalze 8 der Spur B, nicht aber das dort befindliche Gut 1, das von dieser Spurwalze gefördert wird.

Das axiale Verlagern der Nockenscheiben 22 erfolgt bei der in Figur 4 dargestellten bevorzugten Ausführung der Erfindung bei jeder Umdrehung der Welle 7 zweimal. Werden vier Nocken 23 auf den Nockenscheiben 22 symmetrisch angeordnet, dann erfolgt das Korrigieren der Spur viermal pro Umdrehung. Die symmetrische Anordnung der Nocken verhindert ein ansonsten mögliches Verkanten der Nockenscheiben 22 beim axialen Verschieben, wenn dagegen keine andere konstruktive Vorsorge getroffen wird.

Der äußere Randbereich der Nockenscheiben 22 kann, wie dargestellt, gebrochen sein, um ein außergewöhnlich weit aus der Spur gelaufenes Gut in die richtige Richtung abzuweisen.

Die Gegennocken 25 begrenzen zugleich die axiale Verlagerung der Nockenscheiben 22 in der Entspannungsrichtung der Druckfeder 27. Weil die Nockenscheiben 22 sich nur beim Auflaufen der Nocken 23 auf die Gegennocken 25 der Stirnseite 28 der unteren Spurwalze 8 bzw. der ggf. vorhandenen oberen Spurwalze 9 nähern, kann die runde Nockenscheibe auch als rechteckige Lasche oder bei vier Nocken als Kreuz ausgeführt sein.

Das axiale Verlagern der als Korrekturschieber ausgebildeten Korrekturmittel 10, 22 auf den Wellen 7 wurde vorstehend durch Verwendung von Nockensteuerungen beschrieben. Zum Verlagern der Korrekturschieber und der Nockenscheiben können bei besonderen Anwendungen auch andere gesonderte Antriebe verwendet werden, z. B. elektrische oder pneumatische. In diesem Falle entfallen die Nockenbahnen 11 für den Korrekturschieber 10 und die Nocken 23 auf den Nockenscheiben 22. In einer Ausführungsform, die nicht Teil der Erfindung ist, ist dann ein Rotieren der Korrekturmittel 10, 22 auf den Wellen 7 nicht erforderlich. Sie können stationär angeordnet werden.

### Bezugszeichenliste

- 1: Gut, Abschnitt, räumliche Gegenstände
- 2: Untere Transportwalze, Fördermittel
- 3: obere Transportwalze; Fördermittel
- 4: Transportebene
- 5: Antriebspfeil
- 6: Bereichsgrenze
- 7: Welle
- 8: untere Spurwalze
- 9: obere Spurwalze
- 10: Korrekturschieber, Korrekturmittel
- 11: Nockenbahn
- 12: Querlücke
- 13: Abstand
- 14: Hülse
- 15: Justierschraube
- 16: Zwischenstück
- 17: Lager, Wälzlager
- 18: Schenkel
- 19: Anschlag
- 20: Boden
- 21: Transportrichtungspfeil
- 22: Nockenscheibe, Korrekturmittel
- 23: Nocke
- 24: Teilkreis
- 25: Gegennocke
- 26: Konsole
- 27: Druckfeder
- 28: Stirnseite der Spurwalze

## Patentansprüche

1. Vorrichtung zum spurgenauen Transport von Gut (1) als Abschnitte oder räumliche Gegenstände, die in horizontaler Ausrichtung in der Transportebene (4) mindestens von unteren, über rotierende Wellen (7) angetriebenen Fördermitteln (2) als Spurwalzen, Walzen, Rollen, Scheiben oder Rädchen in einer Durchlaufanlage oder auf anderen transportierenden Anlagen förderbar sind, bei der die Fördermittel stirnseitig axial beabstandete Korrekturmittel (10, 22) aufweisen, welche mit den Wellen (7) rotieren und kurzzeitig in Richtung der Stirnseiten (28) verlagerbar sind, wobei dabei ein Gut in dieser Richtung verschoben wird.

2. Vorrichtung nach Patentanspruch 1, **dadurch gekennzeichnet, dass** die Korrekturmittel als rotierende korrekturschieber (10) oder Nockenscheiben (22) mit Nocken (23) ausgebildet sind.

3. Vorrichtung nach Patentanspruch 1 oder 2, **dadurch gekennzeichnet, dass** die Antriebskraft zur Verlagerung der Korrekturmittel von den rotierenden Wellen (7) abgeleitet wird.

4. Vorrichtung nach einem der Patentansprüche 1 bis 3, **dadurch gekennzeichnet, dass** die Verlagerung der Korrekturmittel (10, 22) durch eine Nockensteuerung oder durch einen gesonderten elektrischen oder pneumatischen Antrieb erfolgt.

5. Vorrichtung nach einem der Patentansprüche 1 bis 4, **dadurch gekennzeichnet, dass** sie ferner Nockenbahnen (11) sowie gegebenenfalls einen Boden (20) aufweist, wobei die Nockenbahnen stationär an den rotierenden Wellen (7) angeordnet oder am Boden (20) befestigt sind.

6. Vorrichtung nach einem der Patentansprüche 1 bis 5, **dadurch gekennzeichnet, dass** die Korrekturmittel (10, 22) im entspannten Zustand der auf sie wirkenden Federkräfte nicht an den Stirnseiten (28) der mindestens unteren Fördermittel (2) anliegen.

7. Vorrichtung nach einem der Patentansprüche 1 bis 6, **dadurch gekennzeichnet, dass** die Stirnseiten (28) der mindestens unteren Fördermittel (2) als Anschlag für die Verlagerung der Korrekturmittel (10, 22) wirken.

8. Vorrichtung nach einem der Patentansprüche 1 bis 7, **dadurch gekennzeichnet, dass** die Korrekturmittel (10, 22) an den beiden Seiten der in Transportrichtung (21) positionierten Fördermittel (2) in dieser Richtung wechselseitig angeordnet sind, wodurch das Korrigieren der Spuren in jeder Richtung einer Spur nacheinander erfolgt.

9. Vorrichtung nach einem der Patentansprüche 1 bis 8, **dadurch gekennzeichnet, dass** bei Gut (1), das in Transportrichtung (21) stets gleich lang ist und das fortlaufend mit gleich langer Querlücke (12) beschickt wird, in Verbindung mit synchronisierten Antriebsmitteln der Durchlaufanlage und mit einem Umfang jedes Antriebsmittels, der in einer festen mathematischen Beziehung zur Länge des Gutes plus der Länge der Querlücke (12) steht, die Bewegung(en) der Korrekturmittel (10, 22) durch Nocken (23) erfolgen, wobei diese Nocken so in ihrer Phasenlage eingestellt sind, dass das Gut beim Korrigieren von den Korrekturmitteln (10, 22) so getroffen wird, dass es nicht verdreht wird.

10. Vorrichtung nach Patentanspruch 9, **dadurch gekennzeichnet, dass** der Umfang jedes Antriebsmittels der Länge des Gutes plus der Länge der Querlücke (12) oder einem ganzzahligen Vielfachen dieser Summe entspricht.

11. Vorrichtung nach einem der Patentansprüche 1 bis 10, **dadurch gekennzeichnet, dass** die Korrekturmittel (10, 22) an den unteren Fördermitteln (2) oder an gegebenenfalls vorhandenen oberen Fördermitteln (3) angeordnet sind.

12. Verfahren zum spurgenauen Transport von Gut (1) als Abschnitte oder räumliche Gegenstände, die in horizontaler Ausrichtung in der Transportebene (4) mindestens von unteren, über rotierende Wellen (7) angetriebenen Fördermitteln (2) als Spurwalzen, Walzen, Rollen, Scheiben oder Rädchen in einer Durchlaufanlage oder auf anderen transportierenden Anlagen förderbar sind, unter Verwendung der Vorrichtung nach Patentanspruch 1, wobei ein aus der Spur laufendes Gut (1) von gesteuerten, axial verlagerbaren Korrekturmitteln (10, 22) im Bereich der Transportebene (4) in Richtung zur korrekten Transportspur kurzzeitig geschoben wird.

13. Verfahren nach Patentanspruch 12, **dadurch gekennzeichnet, dass** der Antrieb zum axialen Verlagern der Korrekturmittel (10, 22) mittels Nockenbahnen (11), Nocken (23) und/oder Gegennocken (25) erfolgt.

14. Verfahren nach Patentanspruch 12 oder 13, **dadurch gekennzeichnet, dass** durch eine Anordnung der Nockenbahn (11) oder der Konsole (26) auf der Welle (7) die Korrektur von Höhenabweichungen der Wellen (7) zu den Korrekturmitteln selbsttätig erfolgt.

15. Verfahren nach Patentanspruch 12 oder 13, **dadurch gekennzeichnet, dass** synchronisierte Antriebe der rotierenden Fördermittel (2), die ihrerseits einen Umfang haben, der der Länge des Gutes in Transportrichtung (21) plus der Länge der Querlücke (12) in derselben Richtung entspricht, die Bewegungen der Korrekturmittel (10, 22) mittels Nocken (23, 25) steuern und antreiben.

## Claims

1. Apparatus for the track-true transport of good (1) in the form of segments or spatial objects which are conveyable in horizontal orientation in the transport plane (4) at least by lower conveying means (2) as track rollers, rollers, rolls, discs, or wheels, that are driven by rotating shafts (7) in an in-line plant or on other transporting plants, wherein the conveying means have axially spaced apart correction means (10, 22) on their frontal side which rotate with the shafts (7) and which are temporarily displaceable in direction of the frontal sides (28), thereby displacing a good in this direction.

2. Apparatus according to claim 1, **characterized in that** the correction means are provided as rotating correction pushers (10) or cam discs (22) with cams (23).

3. Apparatus according to claim 1 or 2, **characterized in that** the drive force for displacement of the correction means is derived from the rotating shafts (7).

4. Apparatus according to any of claims 1 to 3, **characterized in that** the displacement of the correction means (10, 22) takes place by means of a cam control or a separate electric or pneumatic drive.

5. Apparatus according to any of claims 1 to 4, **characterized in that** it further has cam tracks (11) as well as optionally a base (20), wherein the cam tracks are stationary arranged at the rotating shafts (7) or attached to the base (20).

6. Apparatus according to any of claims 1 to 5, **characterized in that** the correction means (10, 22) do not bear against the frontal sides (28) of the at least lower conveying means (2), with the spring forces acting against the correction means being in the relaxed state.

7. Apparatus according to any of claims 1 to 6, **characterized in that** the frontal sides (28) of the at least lower conveying means (2) act as end stop for the displacement of the correction means (10, 22).

8. Apparatus according to any of claims 1 to 7, **characterized in that** the correction means (10, 22), transport direction (21), are arranged alternately at both sides of the conveying means (2) being positioned in this direction, whereby the correcting of the tracks takes place successively in each direction of a track.

9. Apparatus according to any of claims 1 to 8, **characterized in that** for good (1) which always has the same length in transport direction (21) and which is continuously fed with an identically long cross gap (12), in connection with synchronized drive means of the in-line plant and with each drive means having a circumference that has a fixed mathematic relation to the length of the good plus the length of the cross gap (12), the motion (s) of the correction means (10, 22) take place by cams (23), wherein these cams are adjusted in their phase position such that the good is hit during correcting by the correction means (10, 22) such that the good is not rotated.

10. Apparatus according to claim 9, **characterized in that** the circumference of each drive means is equivalent to the length of the good plus the length of the cross gap (12) or to an integer multiple of this sum.

11. Apparatus according to any of claims 1 to 10, **characterized in that** the correction means (10, 22) are arranged at the lower conveying means (2) or at optionally present upper conveying means (3).

12. Method for the track-true transport of good (1) in the form of segments or spatial objects which are conveyable in horizontal orientation in the transport plane (4) at least by lower conveying means (2) as track rollers, rollers, rolls, discs, or wheels, that are driven by rotating shafts (7) in an in-line plant or on other transporting plants, by using the apparatus as defined in claim 1, wherein a good (1) that runs off-track is temporarily pushed in the region of the transport track (4) in direction towards the correct transport track by controlled, axially displaceable correction means (10, 22).

13. Method according to claim 12, **characterized in that** the drive for the axial displacement of the correction means (10, 22) takes place by means of cam tracks (11), cams (23), and/or counter cams (25).

14. Method according to claim 12 or 13, **characterized in that** the correction of height deviations of the shafts (7) in regard to the correction means takes place automatically by virtue of the cam track (11) or the console (26) being arranged on the shaft (7).

15. Method according to claim 12 or 13, **characterized in that** the motions of the correction means (10, 22) by cams (23, 25) are controlled and driven by synchronized drives of the rotating conveying means (2), the latter having a circumference that is equivalent to to the length of the good in transport direction (21) plus the length of the cross gap (12) in the same direction.

## Revendications

1. Dispositif pour le transport précis sur une ligne de biens (1) tels que des sections ou des objets tridimensionnels qui sont mobilisables dans une direction horizontale au plan de transport (4) par des transporteurs (2), au moins ceux en dessous de ce plan, actionnés par des arbres rotatifs (7) tels que des cylindres à piste, des cylindres, des rouleaux, des disques ou des roues dans une chaîne continue ou autre installation transporteuse, dans lequel le transporteur est équipé de dispositifs de correction (10, 22) à distance régulière dans l'axe frontal, lesquels tournent avec les arbres (7) et peuvent se déplacer de manière intermittente en direction du coté frontal (28), l'objet étant alors poussé dans cette direction.

2. Dispositif selon la revendication 1, **caractérisé en ce que** les dispositifs de correction sont formés par des leviers de correction (10) rotatifs ou des disques à came(22) avec des ergots (23).

3. Dispositif selon la revendication 1 ou 2, **caractérisé en ce que** la force motrice pour le déplacement des dispositifs de correction est transmise par les arbres rotatifs.

4. Dispositif selon une des revendications 1 à 3, **caractérisé en ce que** le déplacement des dispositif de correction (10, 22) se produit par un entrainement à came ou par une impulsion électrique ou pneumatique distincte.

5. Dispositif selon une des revendications 1 à 4, **caractérisé en ce que** il comprend de plus des culbuteurs (11) ainsi que si nécessaire un plancher (20), les culbuteurs étant fixés de manière stationnaire aux arbres rotatifs ou au plancher (20).

6. Dispositif selon une des revendications 1 à 5, **caractérisé en ce que** les dispositifs de correction (10, 22) reposent à l'état détendu du ressort dont les forces s'exercent sur eux, du coté frontal (28) des dispositifs pour le transport, au moins ceux du dessous.

7. Dispositif selon une des revendications 1 à 6, **caractérisé en ce que** le coté frontal (28) des dispositifs de transport (2), au moins ceux de dessous, agit comme butée pour le déplacement des dispositifs de correction (10, 22).

8. Dispositif selon une des revendications 1 à 7, **caractérisé en ce que** les dispositifs de correction (10, 22) sont alignés des deux cotés des dispositifs de transport (2) positionnés dans le sens du transport (21) dans les deux sens dans cette direction, de cette façon la correction de l'alignement se produit dans chaque sens d'une ligne successivement.

9. Dispositif selon une des revendications 1 à 8, **caractérisé en ce que** pour des objets (1) qui ont la même longueur dans le sens du transport (21) et qui sont chargés en continu à la même distance des uns des autres (12), le (les) déplacement(s) des dispositifs de correction (10, 22) se produit par les ergots (23) en liaison avec les dispositifs moteurs synchronisés de l'installation transporteuse, la circonférence de ces dispositifs moteur étant déterminée par une relation mathématique fixée par la longueur des objets plus la longueur de la distance (12) entre les objets; les ergots étant réglés de telle manière que les objets lors de la correction par les dispositifs de correction (10, 22) sont touchés de telle façon qu'ils ne sont pas tournés.

10. Dispositif selon la revendication 9, **caractérisé en ce que** la circonférence des dispositifs moteur corresponds à la longueur de l'objet plus la longueur de la distance entre les objets (12), ou bien un multiple entier de cette somme.

11. Dispositif selon une des revendications 1 à 10, **caractérisé en ce que** les dispositifs de correction (10, 22) sont alignés sur les dispositifs de transport inférieurs (2) ou supérieurs (3), si présents.

12. Procédé pour le transport précis sur une piste de biens (1) tels que des sections ou des objets tridimensionnels qui sont mobilisables dans une direction horizontale au plan de transport (4) par des transporteurs (2), au moins ceux en dessous de ce plan, actionnés par des arbres rotatifs (7) tels que des cylindres à piste, des cylindres, des rouleaux, des disques ou des roues dans une chaîne continue ou autre installation transporteuse, en utilisant le dispositif selon la revendication 1, un des biens (1) transporté sortant de la ligne sera poussé pendant un temps court en direction de la piste de transport correcte au niveau du plan de transport (4) par les dispositifs de correction (10, 22) guidés, pouvant bouger dans l'axe.

13. Procédé selon la revendication 12, **caractérisé en ce que** la force motrice pouvant bouger dans l'axe les dispositifs de correction (10, 22) se produit par l'intermédiaire de culbuteurs (11), d'ergots (23) et/ou contre-ergots (25).

14. Procédé selon la revendication 12 ou 13, **caractérisé en ce que**, de part un alignement des culbuteurs (11) ou de la console (26) sur l'axe (7), la correction d'écarts de hauteur de l'axe (7) par rapport aux dispositifs de correction se produit automatiquement.

15. Procédé selon la revendication 12 ou 13, **caractérisé en ce que** le mouvement synchronisé des dispositifs de transport rotatifs (2), qui de leur coté ont une circonférence qui est égale à la longueur des biens dans le sens du transport (21) plus la longueur de la distance entre les objets (12) dans la même direction, commande et provoque le mouvement des dispositifs de correction (10, 22) au moyen de cames (23, 25).
